Europäisches Patentamt

European Patent Office

Office européen des brevets

(11) Veröffentlichungsnummer: **0 163 199**

**A2**

(12) **EUROPÄISCHE PATENTANMELDUNG**

(21) Anmeldenummer: 85105950.1

(22) Anmeldetag: 14.05.85

(51) Int. Cl.⁴: **G 03 B 41/00**
**G 03 F 9/00**

(30) Priorität: 29.05.84 DE 3420081

(43) Veröffentlichungstag der Anmeldung:
04.12.85 Patentblatt 85/49

(84) Benannte Vertragsstaaten:
AT CH DE FR GB IT LI NL SE

(71) Anmelder: **Siemens Aktiengesellschaft**
**Berlin und München Wittelsbacherplatz 2**
**D-8000 München 2(DE)**

(72) Erfinder: **Doemens, Günter, Dr.**
**Föchingerstrasse 4**
**D-8150 Holzkirchen(DE)**

(72) Erfinder: **Rosshaupter, Erich, Dipl.-Ing. (FH)**
**Becker-Gundahlstrasse 14d**
**D-8000 München 71(DE)**

(54) **Verfahren und Vorrichtung zur Ermittlung von Deckungsfehlern zwischen nacheinander fotolithografisch auf eine Halbleiterscheibe zu übertragenden Strukturen.**

㊼ Bei der fotolithografischen Strukturübertragung auf Halbleiterscheiben (HS) erfolgt die Maskenjustierung jeweils mit orthogonal zueinander verlaufenden Justierstrukturen (JK) auf der Halbleiterscheibe (HS) und auf der Maske. Bei der Fertigung integrierter Halbleiterschaltungen werden zur Überwachung der fotolithografischen Strukturübertragung zwischen verschiedenen Fototechnikebenen auftretende Deckungsfehler ($\Delta x$, $\Delta y$) nach dem Belichten und Entwickeln des Fotoresists (FR) durch automatische zweidimensionale Lageerkennung und Lagevergleich der Justierstruktur (JK) der Halbleiterscheibe (HS) und der auf das Fotoresist (FR) abgebildeten Justierstruktur (JK') der Maske an einer Vielzahl auf der Halbleiterscheibe (HS) vorgebbarer Meßorte jeweils nach Betrag und Richtung als lokale Deckungsfehler ermittelt. Vorzugsweise werden die lokalen Deckungsfehler mit Hilfe eines Plotters in Form eines Vektorfeldes dargestellt. Durch eine Analyse des Vektorfeldes können verschiedene Anteile der Deckungsfehler ($\Delta x$, $\Delta y$) separiert und gezielt beseitigt werden.

FIG1

Siemens Aktiengesellschaft
Berlin und München

Unser Zeichen
VPA 84 P 1 4 0 3 E

0163199

Verfahren und Vorrichtung zur Ermittlung von Deckungsfehlern zwischen nacheinander fotolithografisch auf eine
Halbleiterscheibe zu übertragenden Strukturen

Die Erfindung betrifft ein Verfahren zur Ermittlung von
nacheinander fotolithografisch auf eine Halbleiterscheibe zu
übertragenden Strukturen nach dem Oberbegriff des Anspruchs
1 und eine Vorrichtung zur Durchführung dieses Verfahrens.

Bei der Herstellung integrierter Halbleiterschaltungen erfolgt der Aufbau der Bauelemente und Strutkuren von einer
Oberfläche einer aus einem Siliziumkristall bestehenden
Halbleiterscheibe her. Der Siliziumkristall dient dabei sowohl als Träger der gesamten Schaltung wie als Halbleiterwerkstoff für die aktiven Bauelemente wie Transistoren und
dgl.. Die im Halbleiter notwendigen unterschiedlichen Dotierungen werden von der Oberfläche der Halbleiterscheibe
her eingebracht, und zwar entweder durch die Diffusionstechnik oder durch die Ionenimplantationstechnik. Meist sind
mehrere Dotierungsschritte nacheinander in verschiedenen
Strukturen notwendig. Es folgen dann die Verbindungs- und
Anschlußleitungen, die auf mit Fenstern versehenen Oxidschichten verlegt werden, auch sie meist in mehreren Strukturlagen übereinander. Die Übertragung der nacheinander herzustellenden Strukturen auf die Halbleiterscheibe erfolgt
auf fotolithografischem Wege, wobei bei jedem Strukturierungsvorgang die Halbleiterscheibe mit einem Fotoresist beschichtet und dann dieses Fotoresist über eine Maske mit der entsprechenden Struktur belichtet und dann entwickelt wird. Bei
kleiner werdenden Strukturdimensionen kommt der Deckungsgenauigkeit der in verschiedenen Fototechnikebenen auf der

Klk 1 Kow / 23.5.1984

-2-

Halbleiterscheibe nacheinander zu erzeugenden Strukturen eine immer größere Bedeutung zu. Die Ursachen von Deckungsfehlern der nacheinander fotolithografisch auf die Halbleiterscheibe zu übertragenden Strukturen liegen dabei in erster Linie bei der Justierung aufeinanderfolgenden Masken zu der Halbleiterscheibe sowie in systematischen Fehlern der verwendeten Belichtungseinrichtung. Eine präzise und umfassende Ermittlung der erzielten Deckungsgenauigkeit könnte daher wichtige Aussagen für die Beherrschung der fotolithografischen Strukturübertragung liefern.

Aus der DE-PS 28 22 269 ist ein Verfahren zur automatischen Maskenjustierung bekannt, bei welchem die Justierung aufeinanderfolgender Masken jeweils mit orthogonal zueinander verlaufenden Justierstrukturen auf der mit einem Fotoresist beschichteten Halbleiterscheibe und auf der Maske vorgenommen wird. Die Justierstruktur der Halbleiterscheibe wird bereits im ersten Strukturierungsvorgang auf der Oberfläche der Halbleiterscheibe beispielsweise durch Ätzen erzeugt, so daß bei sämtlichen nachfolgenden Strukturierungsvorgängen die auf der entsprechenden Maske vorhandenen Justierstrukturen in bezug auf diese erste Justierstruktur ausgerichtet werden können. Zur automatischen Maskenjustierung werden dann die Justierstrukturen auf Maske und Scheibe in parallel zu ihren Kanten verlaufenden Richtungen mit Hilfe eines Bildwandlers optoelektronisch abgetastet, worauf die Intensität der durch die optoelektronische Abtastung erzeugten Bildsignale zeilenweise oder zeilenabschnittsweise aufintegriert wird und die daraus resultierenden analogen Integralwerte in digitale Graustufen umgewandelt und gespeichert werden. Durch Differenzbildung der Graustufen aufeinanderfolgender Zeilen und weitere Auswertung der resultierenden Differenzsignale kann dann die Lage der Mittelachsen der Justierstrukturen erfaßt werden, worauf dann Halbleiterscheibe und Maske zur Justierung entsprechend dem festgestellten Versatz der Mittellinien gegeneinander verschoben werden.

Zur Ermittlung von Deckungsfehlern zwischen nacheinander fotolithografisch auf eine Halbleiterscheibe zu übertragenden Strukturen ist bereits ein visuelles Verfahren bekannt, bei welchem beim ersten Strukturierungsvorgang auf der Halbleiterscheibe geätzte Nonienteilungen erzeugt werden und bei den nachfolgenden Strukturierungsvorgängen jeweils zugeordnete Nonienteilungen der Maske auf die entsprechende Fotoresistschicht übertragen werden. Die Deckungsfehler können dann unter einem Mikroskop an verschiedenen Meßorten der Halbleiterscheibe an den einander zugeordneten Nonienteilungen abgelesen werden. Da das optische Erscheinungsbild der auf der Halbleiterscheibe und dem Fotoresist vorhandene Nonienteilungen äußerst kontrastarm ist und das menschliche Auge rasch ermüdet, sind Einzelmessungen nach diesem visuellen Verfahren sehr zeitintensiv und nur in begrenztem Umfang und mit eingeschränkter Genauigkeit durchführbar. Außerdem erfordern die Nonienteilungen für das visuelle Verfahren spezielle Test-Halbleiterscheiben, d.h. eine Überwachung der fotolithografischen Strukturübertragung in der laufenden Fertigung der integrierten Halbleiterschaltungen ist nicht möglich.

Zur Ermittlung von Deckungsfehlern zwischen nacheinander fotolithografisch auf eine Halbleiterscheibe zu übertragenden Strukturen ist auch bereits ein automatisches elektrisches Verfahren bekannt, bei welchem elektrisch leitende Strukturen an vorgebbaren Stellen über Nadeln abgegriffen werden und vorhandene Unsymmetrien über Widerstandsmessungen und elektrische Brückenschaltungen festgestellt werden. Dieses elektrische Verfahren erfordert jedoch ebenfalls Halbleiterscheiben mit speziellen Teststrukturen und hat

01 63 199
84 P 1 4 0 3 E

darüberhinaus noch den Nachteil, nur in elektrisch leitenden Ebenen anwendbar zu sein.

Der Erfindung liegt die Aufgabe zugrunde, ein Verfahren zur Ermittlung von Deckungsfehlern zwischen nacheinander fotolithografisch auf eine Halbleiterscheibe zu übertragenden Strukturen zu schaffen, welches bei der laufenden Fertigung von integrierten Halbleiterschaltungen eine automatische und präzise Überwachung der fotolithografischen Strukturübertragung in sämtlichen Fototechnikebenen ermöglicht.

Diese Aufgabe wird bei einem gattungsgemäßen Verfahren durch die kennzeichenden Merkmale des Anspruchs 1 gelöst.

Vorteilhafte Ausgestaltungen des erfindungsgemäßen Verfahrens gehen aus den Ansprüchen 2 bis 10 hervor, während aus den Ansprüchen 11 und 12 bis 16 eine Vorrichtung zur Durchführung des erfindungsgemäßen Verfahrens und vorteilhafte Ausgestaltungen dieser Vorrichtung hervorgehen.

Die mit der Erfindung erzielten Vorteile bestehen insbesondere darin, daß für die Ermittlung der Deckungsfehler keine speziellen Teststrukturen sondern die für die Maskenjustierung ohnehin erforderlichen Justierstrukturen herangezogen werden können, sofern die Auswertung durch automatische zweidimensionale Lageerkennung und Lagevergleich dieser Justierstrukturen vorgenommen wird. Eine visuelle Auswertung an einer Vielzahl vorgebbarer Meßorte auf der Halbleiterscheibe wäre nämlich aufgrund des äußerst kontrastarmen optischen Erscheinungsbildes der Justierstrukturen praktisch nicht durchführbar. Da die Deckungsfehler an einer Vielzahl vorgebbarer Meßorte jeweils nach Betrag und Richtung als lokale Deckungsfehler ermittelt werden, lassen sich wichtige Aussagen für die Beherrschung der fotolithografischen Strukturübertragung gewinnen. Insbesondere können dann auch die verschiedenen Fehleranteile, wie z.B. Fehljustierung der Masken, Verzug der Halbleiterscheiben oder Fehljustierung der Belichtungseinrichtung separiert und damit gezielt beseitigt werden. Da die Deckungsfehler direkt an der belichteten und entwickelten Fotoresistschicht ermittelt werden, muß die betreffende Halbleiterscheibe selbst beim Auftreten von unzulässig großen Deckungsfehlern nicht verworfen werden. Nach einer entsprechenden Fehleranalyse und Fehlerbeseitigung, beispielsweise durch Neujustierung der Belichtungseinrichtung, kann die von der Fotoresistschicht befreite Halbleiterscheibe dann nochmals mit einer Fotoresistschicht versehen und neu belichtet werden. Die mit dem erfindungsgemäßen Verfahren ermöglichte Überwachung der fotolithografischen Strukturübertragung führt somit bei der Herstellung integrierter Halbleiterschaltungen zu einer erheblichen Verringerung des Ausschusses.

Ein Ausführungsbeispiel der Erfindung ist in der Zeichnung dargestellt und wird im folgenden näher beschrieben.

Es zeigen:
Figur 1 eine ausschnittsweise Draufsicht auf eine Halbleiterscheibe mit zwei ineinander liegenden Justierkreuzen,

Figur 2 eine ortsrichtig auf die Kontur einer Halbleiterscheibe bezogene vektorielle Darstellung lokaler Deckungsfehler,

Figur 3 eine schematische Darstellung eines bevorzugten Ausführungsbeispiels einer Vorrichtung zur Ermittlung von Deckungsfehlern und

Figur 4 das Prinzip der Erkennung von Deckungsfehlern durch automatische zweidimensionale Lageerkennung und Lagevergleich von zwei Justierstrukturen.

Bei der Herstellung integrierter Halbleiterschaltungen wird beispielsweise in einem ersten Schritt auf eine aus einem Siliziumkristall bestehende Halbleiterscheibe durch eine Glühung in einer sauerstoffhaltigen Atmosphäre eine Oxidschicht erzeugt, die dann mit einem Fotoresist bedeckt wird. Nach der Belichtung mit der gewünschten Struktur läßt sich das Fotoresist beispielsweise an den unbelichteten Stellen weglösen, so daß man dort die Oxidschicht mit Flußsäure entfernen kann. In einer weiteren Wärmebehandlung kann dann an den so freigelegten Stellen ein Dotierstoff in den Siliziumkristall eindringen, während der Rest des Kristalls durch die Oxidschicht geschützt bleibt.

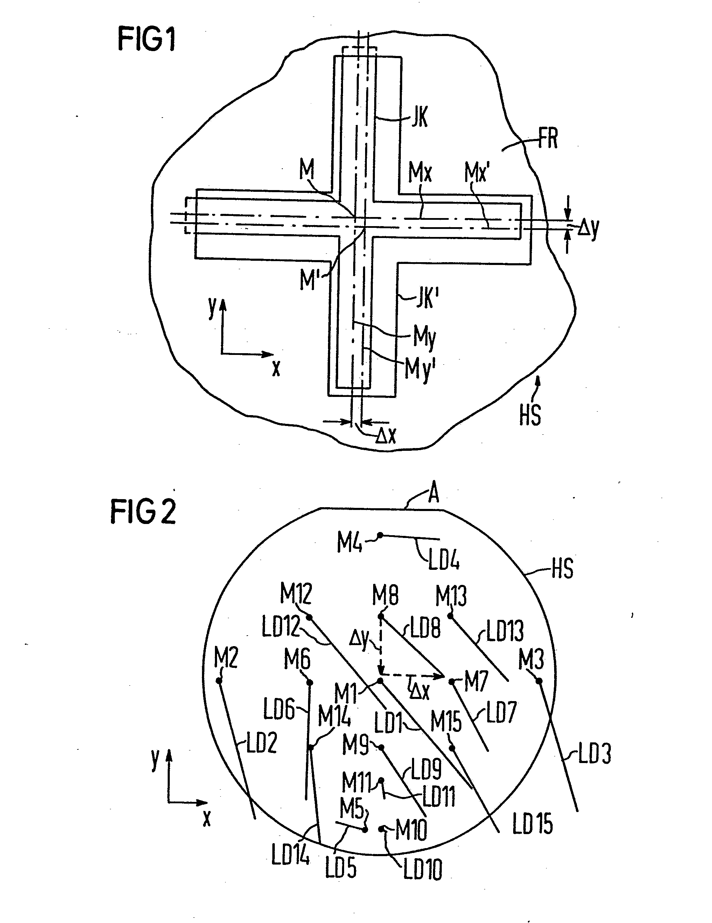

Neben der Herstellung von Strukturen für eine Dotierung können bei den vorstehend beschriebenen ersten Strukturierungsvorgang im Bereich jedes späteren Kristallplättchens bzw. Chips auch Justierstrukturen erzeugt werden, die bei der fotolithografischen Übertragung weiterer Strukturen dann für die Maskenjustierung herangezogen werden. Figur 1 zeigt in einer ausschnittsweisen Draufsicht auf eine Halbleiterscheibe HS eine derartige Justierstruktur JK, die als Justierkreuz ausgebildet ist und gemäß dem beschriebenen Herstellungsgang aus $SiO_2$ besteht. Die Justierstruktur JK könnte aber auch eine andere Form mit orthogonal zueinander verlaufenden Kanten aufweisen oder aus einem anderen Material, beispielsweise aus Metall, bestehen. Bei der fotolithografischen Übertragung weiterer Strukturen wird dann jeweils auf die Halbleiterscheibe HS ein Fotoresist FR aufgebracht und über eine Maske mit der gewünschten Struktur belichtet. Um dabei die Struktur der Maske zur Struktur der Halbleiterscheibe HS präzise zu positionieren, trägt die Maske ebenfalls als Justierkreuze ausgebildete Justierstrukturen, die bei der Maskenjustierung dann so ausgerichtet
werden, daß an zwei Stellen der Halbleiterscheibe HS die
Justierkreuze von Maske und Halbleiterscheibe HS genau ineinanderliegen. Nach dem Belichten und Entwickeln ergeben
sich dann im Fotoresist FR durch die Abbildung der Justierstrukturen der Maske als Justierkreuze ausgebildete Justierstrukturen JK', die als Kanten im Fotoresist FR optisch in
Erscheinung treten.

Treten nun bei der fotolithografischen Strukturübertragung
beispielsweise durch eine Fehljustierung der Maske, durch
einen Verzug der Halbleiterscheibe HS oder durch eine Fehljustierung der Belichtungseinrichtung Deckungsfehler auf, so
können diese an verschiedenen Meßorten durch Lageerkennung
und Lagevergleich der Justierstrukturen JK und JK' ermittelt
werden. In der ausschnittsweisen Draufsicht der Figur 1 ist
ein auf der Halbleiterscheibe HS liegender Meßort M durch
den Schnittpunkt der Mittellinien Mx und My der als Justierkreuz ausgebildeten Justierstruktur JK definiert. Der
Schnittpunkt M' der Mittellinien Mx' und My' der Justierstruktur JK' ist in bezug auf das dargestellte x, y-Koordinatensystem gegenüber dem Meßort M in der positiven x-Richtung um den Betrag $\Delta x$ und in der negativen y-Richtung um
den Betrag $\Delta y$ versetzt, d. h. $\Delta x$ und $\Delta y$ stellen die Komponenten des am Meßort M auftretenden Deckungsfehlers dar.

Ein an einem einzigen Meßort M der Halbleiterscheibe HS
durch seine Komponenten $\Delta x$ und $\Delta y$ ermittelter Deckungsfehler läßt noch keine Rückschlüsse auf die Ursachen der bei
der fotolithografischen Strukturübertragung aufgetretenen
Deckungsfehler zu. Um eine genaue Fehleranalyse und eine Beseitigung der Fehlerquellen zu ermöglichen, müssen die
Deckungsfehler an einer Vielzahl auf der Halbleiterscheibe
HS vorgebbarer Meßorte jeweils nach Betrag und Richtung als lokale Deckungsfehler ermittelt werden.

Figur 2 zeigt eine grafische Darstellung, in welcher für insgesamt 15 der Halbleiterscheibe HS ortsrichtig zugeordnete Meßorte M1 bis M15 die entsprechenden lokalen Deckungsfehler LD1 bis LD15 jeweils nach Betrag und Richtung in Form eines Vektorfeldes aufgezeigt sind. Da die lokalen Deckungsfehler LD1 bis LD15 im Submikrometerbereich liegen, erfolgt die Darstellung ihres Betrages in einem stark vergrößerten Maßstab, welcher von dem für die Darstellung der Halbleiterscheibe HS gewählten Maßstab um mehrere Größenordnungen abweicht. In Übereinstimmung mit Figur 1 ist für den Meßort M8 dargestellt, wie sich der lokale Deckungsfehler LD8 aus seinen Komponenten $\Delta x$ und $\Delta y$ ergibt. Figur 2 zeigt ferner, daß die Halbleiterscheibe HS mit einer Abflachung A versehen ist, welche parallel zur x-Richtung des dargestellten x, y-Koordinatensystems ausgerichtet ist. Über diese Abflachung A können somit auch die orthogonalen Richtungen der Justierstrukturen JK und JK' (vgl. Fig. 1) aufgefunden werden.

Die in Figur 1 als ineinanderliegende Justierkreuze dargestellten Justierstrukturen JK und JK' sind beispielsweise 50 µm groß, wobei die Justierstruktur JK beispielsweise durch Kanten einer Oxidschicht und die Justierstruktur JK' durch Kanten im Fotoresist FR gebildet ist. Durch die unterschiedlichen Prozeßschritte bei der fotolithografischen Strukturübertragung können die Kanten in ihrem optischen Erscheinungsbild äußerst kontrastarm sein und starke Variationen aufweisen. Aus diesem Grunde wäre eine Ermittlung der Deckungsfehler an einer Vielzahl von Meßorten durch visuelle Lageerkennung und visuellen Lagevergleich praktisch nicht durchführbar. Dies kann nur durch automatische zweidimensionale Lageerkennung und Lagevergleich vorgenommen werden, wobei die Nutzung des vollen Informationsgehaltes des optischen Bildes der Justierstrukturen JK und JK' durch eine Grauwertbildverarbeitung unerläßlich ist.

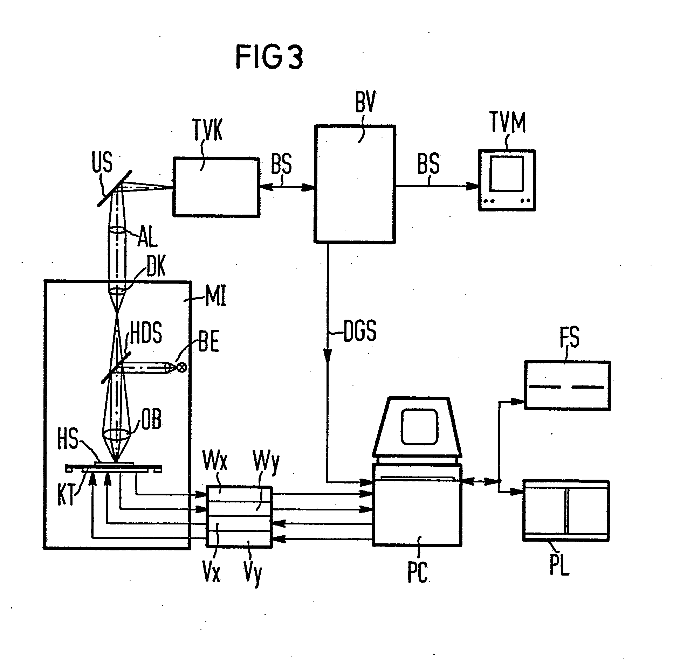

Figur 3 zeigt in stark vereinfachter schematischer Darstellung eine Vorrichtung zur automatischen Ermittlung von Deckungsfehlern. Die Halbleiterscheibe HS wird nach dem Belichten und Entwickeln des nicht näher erkennbaren Fotoresists auf den Kreuztisch KT eines insgesamt mit MI bezeichneten Mikroskops positioniert. Zur Auflichtbeleuchtung der Halbleiterscheibe HS dient eine Beleuchtungseinrichtung BE, deren Lichtstrahlen zwischen Objektiv OB und Okular OK über einen halbdurchlässigen Spiegel HDS in den Strahlengang des Mikroskops MI eingeblendet werden. Nach dem Positionieren der Halbleiterscheibe HS wird dann von einer Bedienperson der Kreuztisch KT so verstellt, daß sich beispielsweise der in Figur 2 dargestellte Meßort M1 direkt unter der optischen Achse OA des Mikroskops MI befindet. Der Meßort M1 kann dann den Nullpunkt eines x, y-Koordinatensystems bilden, wobei die x-Richtung durch die Richtung der Abflachung A (vgl. Figur 2) festgelegt ist. Die an dem Meßort M1 vorhandenen Justierstrukturen JK und JK' (vgl. Figur 1 ) werden dann über das Objektiv OB, das Okular OK, eine Abbildungslinse AL und einen Umlenkspiegel AS auf einen als TV-Kamera ausgebildeten Bildwandler TVK abgebildet. Mit dem Bildwandler TVK werden die Justierstrukturen JK und JK' zunächst mit parallel zur y-Richtung ausgerichteten Zeilen abgetastet, wobei das resultierende Bildsignal BS einer Bildverarbeitungseinrichtung BV zugeführt wird. In dieser Bildverarbeitungseinrichtung BV wird die Intensität der Bildsignale BS zeilenweise aufintegriert, worauf die daraus resultierenden analogen Integralwerte in digitale Graustufen DGS umgewandelt werden und diese digitalen Graustufen in den Arbeitsspeicher eines als Peronalcomputer ausgebildeten Computers PC eingelesen werden. Danach wird über die Bildverarbeitungseinrichtung BV das Zeilenraster im Bildwandler

0163199

84 P 1403 E

TVK elektronisch um einen Winkel von 90° gedreht und der beschriebene Vorgang mit nunmehr parallel zur x-Richtung ausgerichteten Zeilen wiederholt. Die elektronische Bilddrehung
um 90° wird dabei durch Vertauschung der Anschlüsse der
horizontalen und vertikalen Ablenkspulen des Bildwandlers
TVK herbeigeführt. Der Computer PC errechnet dann auf eine
an späterer Stelle noch näher zu beschreibende Weise die
Komponenten $\Delta x$ und $\Delta y$ des dem Meßort M1 ortsrichtig zugeordneten Deckungsfehlers. Die Ortsinformation über den Meßort M1 erhält der Computer PC dabei durch Abfrage von an den
Kreuztisch KT angeschlossenen digitalen Wegmeßeinrichtungen
Wx und Wy.

Die in Figur 2 dargestellten weiteren Meßorte M2 bis M15,
deren Koordinaten in einem auch als Floppystation bezeichneten Speicher FS hinterlegt sind, werden nacheinander über
vom Computer PC numerisch gesteuerte Verstelleinrichtungen
Vx und Vy des Kreuztisches KT angefahren, wobei für jeden
dieser Meßorte M2 bis M15 die Komponenten $\Delta x$ und $\Delta y$ der
ortsrichtig zugeordneten Deckungsfehler errechnet werden.
Die in Figur 2 gezeigte grafische Darstellung der den Meßorten M1 bis M15 ortsrichtig zugeordneten lokalen Deckungsfehler LD1 bis LD 15 erfolgt dann mit Hilfe eines an den
Computer PC angeschlossenen Plotters PL.

Figur 3 zeigt ferner, daß die Bildsignale BS des Bildwandlers TVK auch einem TV-Monitor TVM zugeführt werden. Das
Fernsehbild des TV-Monitors TVM dient dabei als Orientierungshilfe beim Anfahren des ersten Meßortes bzw. als Kontrolle für das automatische Anfahren der weiteren Meßorte.

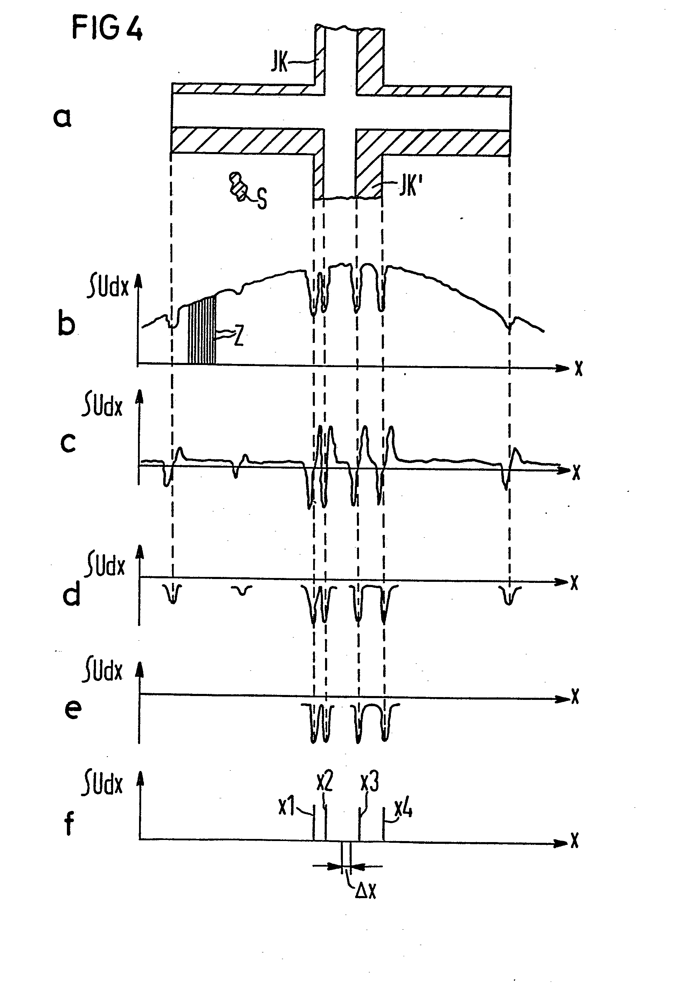

Die Bildverarbeitung in der Bildverarbeitungseinrichtung BV
und dem Computer PC wird anhand der Figuren 4a bis 4f näher
erläutert. Dabei zeigt die Figur 4a die bereits in Figur 1 dargestellten Justierstrukturen JK und JK', deren Zwischenbereich hier jedoch zur Verdeutlichung des vorhandenen
Deckungsfehlers durch eine Schraffur hervorgehoben ist.
Außerdem ist in Figur 4a noch ein im Fotoresist FR (vgl.
Figur 1) enthaltenes Störpartikel S dargestellt.

Die Justiersturkturen werden mit orthogonal zur x-Richtung
verlaufenden Zeilen abgetastet, worauf die Intensität der
resultierenden Bildsignale zeilenweise aufintegriert wird.
Als Ergebnis dieser analogen Integration ist in Figur 4b
über der x-Richtung das $\int U dx$ aufgetragen, wobei mit U die
analoge Spannung der Bildsignale bezeichnet ist. Links in
der Figur 4b ist durch einige Zeilen Z die Abtastrichtung
angedeutet. Weiterhin ist zu erkennen, daß sämtliche
parallel zur Zeilenrichtung verlaufenden Kanten der
Justierstrukturen JK und JK' und das Störpartikel S durch
Einbuchtungen in der Kurve der Integralwerte in Erscheinung
treten.

Die Integralwerte werden dann einer zeilenweisen Differenzbildung unterzogen, deren Ergebnis in Figur 4c dargestellt
ist. Anschließend wird das so vorliegende und vorverdichtete
analoge Bildsignal zeilenweise digitalisiert und in den
Arbeitsspeicher des in Figur 3 dargestellten Computers PC
eingelesen. In dem Computer PC erfolgt dann gemäß Figur 4d
eine Korrelation, bei welcher die Extremwerte ausgesucht und
die Lage der Extremwerte zueinander bestimmt wird. An diese
Korrelation schließt sich eine Wertereduzierung an, nach
welcher gemäß Figur 4e nur noch die vier größten Extremwerte in Erscheinung treten.

Gemäß Figur 4f können den in Figur 4e dargestellten vier
größten Extremwerten in x-Richtung die Koordinaten x1, x2,
x3 und x4 zugeordnet werden, die gleichzeitig die Lage der
Kanten der der in Figur 4a dargestellten Justierstrukturen

-12-

JK und JK' angeben. Die Lage der Mittellinien der Justierstrukturen JK und JK' bestimmen sich dann zu

$$\frac{x2 + x3}{2} \quad \text{bzw.} \quad \frac{x1 + x4}{2} \quad ,$$

während sich die gesuchte x-Richtung verlaufende Komponente
$\Delta x$ des Deckungsfehlers als Abstand dieser beiden Mittellinien ergibt.

Nach einer elektronischen Drehung des Zeilenrasters des in
Figur 3 dargestellten Bildwandlers TVK wird der in den
Figuren 4a bis 4f beschriebene Vorgang in entsprechender
Weise zur Bestimmung der in y-Richtung verlaufenden Komponente $\Delta y$ des Deckungsfehlers wiederholt. Ein Vergleich der
derart durchgeführten Ermittlung von Deckungsfehlern mit dem
bekannten elektrischen Verfahren ergab eine Übereinstimmung
im Bereich von $\pm$ 0,05 µm, womit auch die Anwendbarkeit des
erfindungsgemäßen Verfahrens für Submikrometerstrukturen
sichergestellt ist. Die vektorielle Darstellung der lokalen
Deckungsfehler gemäß Figur 2 ermöglicht eine Fehleranalyse,
wobei diese Fehleranalyse aber auch durch weitere auf dem
Computer PC (vgl. Figur 3) ablauffähige Programme als
mathematische Interpretation des Vektorfeldes vorgenommen
werden kann. Die in Figur 2 in Form eines Vektorfeldes
aufgezeigten Meßergebnisse ermöglichen beispielsweise
folgende Aussagen:

- Bei der Belichtung des Fotoresists FR ist eine Verzeichnung der übertragenden Optik aufgetreten;
- Bei der Maskenjustierung ist ein Justierfehler aufgetreten;
- Die Halbleiterscheibe HS hat sich verzogen.

Aufgrund dieser Aussagen können dann die verwendete Belichtungseinrichtung nachjustiert und die Fehler bei der Maskenjustierung beseitigt werden.

16 Patentansprüche
4 Figuren

Patentansprüche

1. Verfahren zur Ermittlung von Deckungsfehlern zwischen nacheinander fotolithografisch auf eine Halbleiterscheibe zu übertragenden Strukturen, wobei die Justierung aufeinanderfolgender Masken jeweils mit orthogonal zueinander verlaufenden Justierstrukturen auf der mit einem Fotoresist beschichteten Halbleiterscheibe und auf der Maske vorgenommen wird, dadurch gekennzeichnet, daß die Deckungsfehler ($\Delta x$, $\Delta y$) nach dem Entwickeln des Fotoresists (FR) durch automatische zweidimensionale Lageerkennung und Lagevergleich der Justierstruktur (JK) der Halbleiterscheibe (HS) und der auf das Fotoresist (FR) abgebildeten Justierstruktur (JK') der Maske an einer Vielzahl auf der Halbleiterscheibe (HS) vorgebbarer Meßorte (M1 bis M15) jeweils nach Betrag und Richtung als lokale Deckungsfehler (LD1 bis LD15) ermittelt werden.

2. Verfahren nach Anspruch 1, dadurch gekennzeichnet, daß auf der Halbleiterscheibe (HS) und im Fotoresist (FR) Justierstrukturen (JK, JK') erzeugt werden, die an jedem Meßort (M1 bis M15) die Form von zwei ineinander liegenden Justierkreuzen aufweisen.

3. Verfahren nach Anspruch 1 oder 2, dadurch gekennzeichnet, daß die automatische zweidimensionale Lageerkennung der Justierstrukturen (JK, JK') folgende Schritte umfaßt:

- die Justierstrukturen (JK, JK') werden in parallel zu ihren Kanten verlaufenden Richtungen optoelektronisch abgetastet,

- die Intensität der durch die optoelektronische Abtastung erzeugten Bildsignale (BS) wird zeilenweise oder zeilenabschnittsweise aufintegriert,

- die daraus resultierenden analogen Integralwerte werden in digitale Graustufen (DGS) umgewandelt,
- die digitalen Graustufen (DGS) werden zur weiteren Bildverarbeitung in den Arbeitsspeicher eines Computers (PC) eingelesen.

4. Verfahren nach Anspruch 3, dadurch   g e k e n n - z e i c h n e t   , daß die Integralwerte einer zeilenweisen Differenzbildung unterzogen werden und daß dann die Extremwerte der daraus resultierenden Differenzsignale ermittelt werden und die Lage der den Justierstrukturen (JK, JK') zugeordneten Extremwerte zueinander bestimmt wird.

5. Verfahren nach Anspruch 4, dadurch   g e k e n n - z e i c h n e t   , daß die den Justierstrukturen (JK, JK') zugeordneten Extremwerte durch eine Auswahl der größten Extremwerte der Differenzsignale ermittelt werden.

6. Verfahren nach einem der Ansprüche 3 bis 5, dadurch   g e k e n n z e i c h n e t   , daß die Justierstrukturen (JK, JK') mit Hilfe eines Bildwandlers (TVK) abgetastet werden, dessen Zeilenraster zur Erzielung einer zur ersten Abtastrichtung orthogonalen zweiten Abtastrichtung elektronisch um einen Winkel von $90^\circ$ gedreht wird.

7. Verfahren nach einem der vorhergehenden Ansprüche, dadurch   g e k e n n z e i c h n e t   , daß die durch die optoelektronische Abtastung erzeugten Bildsignale (BS) zur optischen Darstellung des jeweiligen Meßortes (M1 bis M15) und seiner Umgebung einem TV-Monitor (TVM) zugeführt werden.

8. Verfahren nach einem der vorhergehenden Ansprüche, dadurch   g e k e n n z e i c h n e t   , daß die Halb-

leiterscheibe (HS) auf einem Kreuztisch (KT) positioniert wird und daß die Meßorte (M1 bis M15) nacheinander durch Verstellen des Kreuztisches (KT) angefahren werden.

9. Verfahren nach Anspruch 8, dadurch  g e k e n n - z e i c h n e t  , daß das Anfahren der Meßorte (M1 bis M15) entsprechend einem vorgebbaren Programm numerisch gesteuert wird.

10. Verfahren nach einem der vorhergehenden Ansprüche, dadurch  g e k e n n z e i c h n e t  , daß der Halb- leiterscheibe (HS) ein festes kartesisches Koordinatensystem zugeordnet wird und an jedem Meßort (M1 bis M15) die Komponenten der Deckungsfehler ( $\Delta$x, $\Delta$y) in beiden Koordi- natenrichtungen (x, y) ermittelt werden und daß die lokalen Deckungsfehler (LD1 bis LD15) dann nach Betrag und Richtung unter ortsrichtigem Bezug auf die Halbleiterscheibe (HS) als Vektorfeld grafisch dargestellt werden.

11. Vorrichtung zur Durchführung des Verfahrens nach Anspruch 1,  g e k e n n z e i c h n e t  durch
- ein Mikroskop (MI) zur Abbildung der an vorgebbaren Meßorten (M1 bis M15) einer Halbleiterscheibe (HS) vorhandenen Justierstrukturen (JK, JK') auf einen Bildwandler (TVK),
- eine an den Bildwandler (TVK) angeschlossene Bildverarbeitungseinrichtung (BV) zur zeilenweisen oder zeilenabschnittsweisen Aufintegration und Digitalisierung der Bildsignale (BS) des Bildwandlers (TVK) und
- einen Computer (PC) in dessen Arbeitsspeicher die in der Bildverarbeitungseinrichtung (BV) erzeugten digitalisierten Integralwerte einlesbar sind.

12. Vorrichtung nach Anspruch 11, dadurch  g e k e n n - z e i c h n e t  , daß durch die Bildverarbeitungsein-

richtung (BV) das Zeilenraster des Bildwandlers (TVK)
elektronisch um 90° drehbar ist.

13. Vorrichtung nach Anspruch 11 oder 12, dadurch  g e -
k e n n z e i c h n e t     , daß die Bildsignale (BS) des
Bildwandlers (TVK) einem TV-Monitur (TVM) zuführbar sind.

14. Vorrichtung nach einem der Ansprüche 11 bis 13, dadurch
g e k e n n z e i c h n e t     , daß die Halbleiterscheiben
(HS) auf einem Kreuztisch (KT) des Mikroskops (MI) positionierbar sind und daß dem Kreuztisch (KT) numerisch
steuerbare Verstelleinrichtungen (Vx, Vy) und digitale Wegmeßeinrichtungen (Wx, Wy) zugeordnet sind.

15. Vorrichtung nach Anspruch 14, dadurch  g e k e n n -
z e i c h n e t , daß die Koordinaten (x, y) der über den
Kreuztisch (KT) anfahrbaren Meßorte (M1 bis M15) in einem an
den Computer (PC) angeschlossenen Speicher (FS) hinterlegbar sind.

16. Vorrichtung nach einem der Ansprüche 11 bis 15, dadurch
g e k e n n z e i c h n e t     , daß an den Computer (PC)
ein Plotter (PL) zur grafischen Darstellung der lokalen
Deckungsfehler (LD1 bis LD15) als Vektorfeld angeschlossen
ist.

FIG 1

FIG 2

0163199

## FIG 3

FIG 4